**Europäisches Patentamt**

(19) **European Patent Office**

**Office européen des brevets**

(11) Publication number : **0 325 453 B1**

(12) # EUROPEAN PATENT SPECIFICATION

(45) Date of publication of patent specification :
07.12.94 Bulletin 94/49

(51) Int. Cl.⁵ : **G01R 31/26,** G01R 29/24, H01L 21/66

(21) Application number : **89300496.0**

(22) Date of filing : **19.01.89**

(54) Noninvasive method for characterization of semiconductors.

(30) Priority : **20.01.88 US 145923**
**21.03.88 US 171677**
**07.12.88 US 280793**

(43) Date of publication of application :
**26.07.89 Bulletin 89/30**

(45) Publication of the grant of the patent :
**07.12.94 Bulletin 94/49**

(84) Designated Contracting States :
**AT BE CH DE ES FR GB GR IT LI LU NL SE**

(56) References cited :
**EP-A- 0 077 021**
**DE-A- 3 116 611**
**US-A- 4 333 051**
**US-A- 4 544 887**

(56) References cited :
**REVIEW OF SCIENTIFIC INSTRUMENTS, vol. 54, no. 9, September 1983, pages 1165-1168, American Institute of Physics, New York, US; S. HASEGAWA:** "Improveddifferential photo-current method for measurement of optical-absorptioncoefficient and minority-carrier dif-fusion length in a semiconductor"

(73) Proprietor : **SEMITEST, INC.**
**46 Manning Road**
**Billerica Massachusetts 01821 (US)**

(72) Inventor : **Kamieniecki, Emil**
**30 Carville Avenue**
**Lexington, MA 02173 (US)**
Inventor : **Wollowitz, Michael**
**51 Dana Street**
**Cambridge, MA 02138 (US)**
Inventor : **Goldfarb, William C.**
**48 Woodcrest Drive**
**Melrose, MA 02176 (US)**

(74) Representative : **Jackson, David Spence et al**
**REDDIE & GROSE**
**16, Theobalds Road**
**London, WC1X 8PL (GB)**

EP 0 325 453 B1

## Description

## NONINVASIVE METHOD AND APPARATUS FOR CHARACTERIZATION OF SEMICONDUCTORS

The present invention relates generally to the characterization of semiconductors and more particularly to the characterization of semiconductor materials and devices using an ac surface photovoltage (SPV) method to determine the surface space charge capacitance. The invention is particularly useful in determining parameters such as the surface state density of a semiconductor and/or an oxide/insulator charge in a dielectric film which may be formed on a semiconductor, either naturally or intentionally (i.e. by thermal oxidation), but, as will hereinafter be pointed out, may be used in determining other parameters of a semiconductor.

As is know the surface state density of a semiconductor is useful, for example, in indicating the quality and contamination of a semiconductor surface or of the interface between the semiconductor and an oxide coating which may be formed on a semiconductor while the oxide/insulator charge is useful in indicating the quality and contamination of the oxide/insulator coating itself.

The surface photovoltage effect as applied to semiconductors and techniques for measuring the (ac) surface photovoltage so as to determine characteristics such as the surface space charge capacitance in general are well know in the art.

Known patents of interest relating to the surface photovoltage effect include U.S. patent 4,544,887, issued on October 1, 1985 in the name of E. Kamieniecki, which discloses a method of measuring photo-induced voltage at the surface of semiconductor materials (i.e. the surface photovoltage); U.S. patent 4,286,215, issued on Aug. 25, 1981 in the name of G.L. Miller, which discloses a method and apparatus for the contactless monitoring of the carrier lifetime in semiconductor materials; U.S. patent 4,333,051, issued on June 1, 1982 in the name of A.M. Goodman, which discloses a method and apparatus for determining minority carrier diffusion length in semiconductors; U.S. patent 4,333,288, issued on February 21, 1984 in the name of A.R. Moore, which discloses a method and apparatus for determining minority carrier diffusion length in semiconductors; and U.S. patent 4,663,526, issued on May 5, 1987 in the name of E. Kamieniecki, which discloses a method and apparatus for the nondestructive readout of a latent electrostatic image formed on an insulating material.

Know publications of interest relating to the characterization of semiconductors and/or the surface photovoltage effect in general include Emil Kamieniecki, "Surface Photovoltage Measured Capacitance: Application To Semiconductor/Electrolyte System", J. Appl. Phys. Vol. 54, No. 11, November, 1983, pp. 6481-6487; Emil Kamieniecki, "Determination of surface space charge capacitance using a light probe", J. Vac. Sci. Technol., Vol. 20, No. 3, March, 1982, pp. 811-814; Hiromichi Shimizu, Kanji Kinameri, Noriaki Honma and Chusuke Munakata, "Determination of Surface Charge and Interface Trap Densities in Naturally Oxidized n-Type Si Wafers Using ac Surface Photovoltages", Japanese Journal of Applied Physics, Vol. 26, No. 2, February, 1987, pp. 226-230; A. Sher, Y.H. Tsuo, John A. Moriarty, W.E. Miller and R.K. Crouch, "Si and GaAs Photocapacitive MIS Infrared Detectors", J. Appl. Phys., Vol. 51, No. 4, April 1980, pp. 2137-2148; Olof Engstrom and Annelle Carlsson, "Scanned Light Pulse Technique For the Investigation of Insulator-semiconductor Interfaces", J. Appl. Phys. Vol. 54, No. 9, September, 1983, pp. 5245-5251; E. Thorngren and O. Engstrom, "An Apparatus for the Determination of Ion Drift in MIS Structures". J. Phys. E: Sci. Instrum., Vol. 17, 1984, printed in Great Britain, pp. 1114-1116; E. Kamieniecki and G. Parsons, "Characterization of Semiconductor-Electrolyte System by Surface Photovoltage Measured Capacitance", 164th meeting of the Electrochemical Society, Washington, D. C. October, 1983; R.R. Chang, D.L. Lile and R. Gann, "Remote Gate Capacitance-Voltage Studies for Noninvasive Surface Characterization", Appl. Phys. Lett. Vol. 51, No. 13, September, 28, 1987, pp. 987-989; Chusuke Munakata, Shigeru Nishimatsu, Noriaki Honma and Kunihiro Yagi, "Ac Surface Photovoltages in Strongly-Inverted Oxidized p-Type Silicon Wafers", Japanese Journal of Applied Physics, Vol 23, No. 11, November 1984, pp. 1451-1461; R.S. Nakhmanson, "Frequency Dependence of the Photo-EMF of Strongly Inverted Ge and Si MIS Structures - I. Theory", Solid State Electronics, 1975, Vol 18, pp. 617-626, Pergamon Press, Printed in Great Britain; R.L. Streever, J.J. Winter and F. Rothwarf, "Photovoltage Characterization of MOS Capacitors", Pro. Int. Symp. Silicon Materials Sci & Tech., Philadelphia, May 1977 (Electrochem. Soc. Princeton, 1977) pp. 393-400; R.S. Nakhmanson, Z. Sh. Ovsyuk and L.K. Popov, "Frequency Dependence of Photo-EMF of Strongly Inverted Ge and Si MIS Structures - II Experiments", Solid State Electronics, 1975, Vol. 18, pp. 627-634 Pergamon Press, Printed in Great Britain; Chusuke Munakata and Shigeru Nishimatsu, "Analysis of ac Surface Photovoltages i n a Depleted Oxidized p-Type Silicon Wafer", Japanese Journal of applied Physics, Vol 25, No. 6, June, 1966, pp. 807-812; Chusuke Munakata, Mitsuo Nanba and Sunao Matsubara, "Non-Destructive Method of Observing Inhomogeneities in p-n Junctions with a Chopped Photon Beam", Japanese Journal of Applied Physics, Vol. 20, No. 2, February, 1981, pp. L137-L140; Chusuke Munakata and Shigeru Nishimatsu, "Analysis of ac Surface Photovoltages in a Depleted Oxidized p-Type Silicon Wafer", Japanese Journal of Applied Physics, Vol 25, No. 6, June, 1986, pp. 807-812; S.M. Sze, "MIS Diode and Charge-Coupled Device", Physics of Semiconductor Devices, John Wiley & Sons Inc. New York 1981, second edition, pp. 362-394.

The front-end of a typical semiconductor device fabrication line involves numerous steps after the initial scrubbing and cleaning of the raw wafer. These steps include oxidation, deposition, masking, diffusion, and implant operations. It can take several weeks from start to finish and testing of the final product. As can be appreciated, process variations which cause yield losses that are detected only at the end of the wafer fabrication cycle are an economic disaster for manufacturers.

The present invention is defined by claim 1 hereinafter to which reference should now be made.

This invention can be used in monitoring contamination and defects of a semiconductor surface (interface) and/or of a dielectric film which may be coating a semiconductor and/or of a device, such as a metal-oxide-semiconductor or a metal-insulator-semiconductor, which includes a layer of semiconductor material. The invention is also applicable to determining the doping type and the doping concentration of a semiconductor in the region adjacent to the (front) surface. One of the most important applications of a technique utilising this invention is in connection with silicon device fabrication and in particular monitoring of the oxidation processes used in the fabrication of such devices. However, the technique may also find application in monitoring of other processes such as implantation and diffusion as well as in monitoring processing of semiconductor materials other than silicon, such as for example, gallium arsenide or mercury cadmium telluride.

As will hereinafter be explained, the present invention addresses the use of the (ac) surface photovoltage effect developed under certain specific conditions for the characterization of the bulk and surface (interface) properties of semiconductors. The semiconductor specimen being examined may be bare or may be coated with single layer of dielectric material such as a native oxide (e.g.,$Si/SiO_2$) or a multi-layer dielectric coating (e.g.,$Si/SiO_2/polyimide$, $Si/SiO_2/Si_3N_4$,etc.) or may be an MIS (metal-insulator-semiconductor) or MOS (metal-oxide-semiconductor) device. More specifically, the present invention makes use of the known fact that the (ac) surface photovoltage signal (the voltage photo-induced at the surface of a semiconductor) when measured under certain defined conditions is proportional to the reciprocal of the semiconductor space-charge capacitance.

The defined conditions of measurement are as follows: (1) the wavelength of the illuminating light is shorter than that corresponding to the energy gap of the semiconductor material, (2) the light is intensity modulated with the intensity of the light and the frequency of modulation being selected such that the induced (ac) voltage signal is directly proportional to the intensity of light and reciprocally proportional to the frequency of modulation.

When the surface of the specimen is illuminated uniformly this relationship maybe expressed as

$$\delta V_s = \frac{\phi(I - R)}{Kf} q C_{sc}^{-1}$$

where $\delta V_s$ is the surface photovoltage, C is the space charge capacitance, $\phi$ is the incident photon flux, R is the reflection coefficient of the semiconductor material, f is the modulation frequency of the light, and q is the electron charge, K is equal to 4 for squarewave modulation of light intensity and is equal to $2\pi$ for sinusoidal modulation. Details on the derivation of this relationship are presented in the above noted paper by Emil Kamieniecki entitled "Determination of Surface Space Charge Capacitance Using A Light Probe" published in the Journal of Vacuum Science Technology, Vol. 20, No. 3, Mar. 1982, pages 811-814. If the illumination of the semiconductor surface is local and not uniform, $\delta V_s$ is determined by using the equation $\delta V_m = (s/S)\delta V_s$ where $V_m$ is the output voltage s is the area of the illuminated portion (plus diffusion) and S is the total area of the semiconductor. $C_{sc}$ is then determined using the equation noted above.

U.S. Patent 4,544,887, cited above, describes two specific arrangements for measuring the photo-induced voltage at the surface of a specimen of semiconductor material under the conditions noted above, namely, (i) for a specimen of semiconductor material placed in a suitable electrolyte, and (ii) for a specimen of semiconductor material spaced from the reference electrode by an insulating medium such as a gas or a vacuum. However, each arrangement has its shortcomings. The gas or vacuum arrangement is particularly unsatisfactory because of the electrostatic force of attraction between charges induced on opposing faces of the reference electrode and the semiconductor which tend to deflect the semiconductor towards the reference electrode resulting in nonlinearities in the system and the generation of spurious signals while the electrolyte arrangement will cause changes (contamination) in the surface being tested. U.S. patent 4,544,887 further suggest that the surface photovoltage so determined may be used to characterize properties of a semiconductor material using "conventional" capacitance analysis. However, no method, conventional or nonconventional, which can be used for actually characterizing semiconductor materials once the surface photovoltage has been detected using the disclosed conditions is actually described in the patent. Similar equations establishing the proportionality between the surface photovoltage and the space charge capacitance along with the relation and conditions of measurement in connection with MIS devices are found in the Sher, etc. article noted above and the Nakhamson article (1975), also noted above. Equation 16 in the Nakhamson article deals with the imaginary component of the surface photovoltage signal.

A preferred embodiment of the present invention, as will hereinafter be shown, provides an arrangement for measuring the surface photovoltage in a way which is useful for characterization of semiconductors, especially, but not limited to, semiconductors in the form of wafers and, in addition, a method of actually determining a number of parameters of the semiconductor once the surface photovoltage is so obtained, the method for determining the parameters being different from conventional and known capacitance analysis techniques.

As will hereinafter be pointed out, one of the main features of the present technique for characterizing semiconductors by using low intensity modulated light generated surface photovoltage involves the use of the dependence of the photovoltage signal so detected on a bias voltage. Another and very important feature is the way in which the parameters of the semiconductor specimen are derived from this dependence.

Measurements of surface photovoltage (generated due to low intensity illumination) versus bias voltage, in general, are very well know. R.L. Streever, J.J. Winter and F. Rothwarf in an article entitled, "Photovoltage Characterization of MOS Capacitors" published in Proc. Int. Symp. Silicon Materials Sci. & Tech., Philadelphia, May 1977 (Electrochem. Soc., Princeton, 1977) pp. 393 400; A. Sher, Y.H. Tsuo, and John A. Moriarty in an article entitled, "Si and GaAs Photocapacitive MIS Infrared Detectors" published in the Journal of applied Physics Vol. 51, No. 4, April 1980, pages 2137-2148; Olof Engstrom and Annelie Carlsson in an article entitled, "Scanned Light Pulse Technique for the Investigation of Insulator-semiconductor Interfaces" published in the Journal of Applied Physics Vol. 54, No. 9, September 1983, pages 5245-5251; and E. Thorngren and O. Engstrom in an article, "An Apparatus for the Determination of Ion Drift in MIS Structures" published in J. Phys. E: Sci. Instrum., Vol. 17, 1984, pp. 1114-1116 all disclose such measurements.

One of the shortcomings with the systems disclosed in the above articles is that they are all limited to MIS or MOS structures. The present invention, on the other hand, is not limited to such structures but rather is applicable (1) to arrangements in which a semiconductor wafer (eventually having a dielectric coating) and an insulator which is used to separate the semiconductor from a conductive electrode for SPV testing are separate elements and (2) to MIS or MOS structures, in which the insulator and the semiconductor are a unitary structures (permanently integrated). From the point of view of the system characteristic and method of characterization, the main difference between the arrangement where the semiconductor and the insulator are a unitary structure and the arrangement where the insulator and the semiconductor are separate elements is that the insulator in the unitary structure is much thinner than the insulator in the non-unitary structure. More specifically, while the insulator thickness in MIS/MOS structures is typically around 1000A or less, the typical thickness of the separately formed insulator arrangement is typically around 10μm (about 100 times thicker). Therefore to achieve similar changes in the semiconductor space-charge region using a separately formed (thicker) insulator requires about 100 times higher bias voltage (e.g. around 500 volts as opposed to about 5 volts). Because of this much higher bias voltage, the conventional analysis technique used for capacitance-voltage measurements and used for ac surface photovoltage in MIS/MOS structures cannot be used when a thick insulator is being used.

The conventional approach for capacitance-voltage measurements makes use of the distribution of the bias voltage $(V_g)$ between the insulator $(V_i)$ and the semiconductor $(V_s)$ i.e. $(V_g=V_i+V_s)$, to evaluate the relation between the surface potential $V_s$ and the applied voltage $V_g$; for conventional capacitance analysis see Chapter 7 of the book by S.M. Sze, noted above, for surface photovoltage see page 5248 in the paper by Engstrom et al. noted above. With a 10μm thick insulating spacer (such as a sheet of Mylar) the bias voltage $V_g$ is hundreds of times higher than surface potential $V_s$. Consequently, an error in evaluation of the voltage drop across the insulator $(V_i)$ due to e.g., uncertainty in the thickness of the insulating spacer and hence its capacitance $C_i(V_i=Q_{ind}/C_i)$ where $Q_{ind}$ is the charge induced in the semiconductor) makes evaluation of the surface potential from the applied voltage impractical.

The measurement of the surface photovoltage versus the combination of the incident light and the modulating frequency of the light is shown in U.S. Patent 4,544,887 noted above.

It is also known to determine the capacitance in a semiconductor for characterization purposes by measuring AC current rather than surface photovoltage.

A preferred embodiment of this invention provides a method for characterizing semiconductor materials (either coated with an insulator or uncoated) and semiconductor devices using the surface photovoltage effect;

a method as described above which involves determining the surface space charge capacitance;

a method as described above which is specifically suited for use with thick insulators which can also be used, if desired, with thin insulators;

a method as described above which may be used for determining surface state (interface trap) density;

a method as described above which may be used for determining the oxide/insulator charge;

a method as described above which may be used for determining doping type;

a method as described above which may be used for determining doping concentration;

a method as described above which is non-invasive;

a method for use in characterizing a semiconductor wafer; and

apparatus for making ac surface photovoltage measurements of a specimen of semiconductor material;

apparatus for making ac surface photovoltage measurements of a specimen of semiconductor material under dc bias voltage conditions;

capacitive type reference electrode for use in making ac surface photovoltage measurements of a specimen of semiconductor material.

a reference electrode assembly which is especially constructed for use in an apparatus for making ac surface photovoltage measurements of a specimen of semiconductor material under high dc bias voltage conditions.

A preferred embodiment of the present invention makes use of the fact that the photovoltage at the surface of a semiconductor (SPV), measured with low intensity modulated light under certain defined conditions is proportional in a known way to the reciprocal of the space-charge capacitance $C_{sc}$. More specifically, when the surface of the specimen is illuminated uniformly $\delta V_m = \delta V_s$ and $C_{sc}$ is determined by the equation

$$\delta V_s = \frac{\phi(l-R)}{Kf} \times q \times C_{sc}^{-1}$$

where $\delta V_s$ is the surface photovoltage, $C_{sc}$ is the space charge capacitance, $\phi$ is the incident photon flux, R is the reflection coefficient of the simiconductor material, f is the modulation frequency of the light, and q is the electron charge, K is equal to 4 for squarewave modulation of light intensity and is equal to $2\pi$ for sinusoidal modulation. Details on the derivation of the relationship are presented in the paper by Emil Kamieniecki entitled "Determination of Surface Space Charge Capacitance Using a Light Probe" published in the Journal of Vacuum Science Technology, Vol. 20, No. 3, Mar. 1982, pages 811-814. If the illumination of the semiconductor surface is local and not uniform, $\delta V_s$ is determined by using the equation $\delta V_m = (s/S)\delta V_s$ where $\delta V_m$ is the output voltage is in the area of the illuminated portion (plus diffusion) and S is the total area of the semiconductor. $C_{sc}$ is then determined using the equation noted above.

The space charge capacitance ($C_{sc}$) when determined under the conditions noted above is used to determine both the surface potential ($V_s$) and the width of the depletion layer and hence the charge induced in the semiconductor space-charge region ($Q_{sc}$). The applied or bias voltage ($V_g$) is used to evaluate the charge induced in the semiconductor ($Q_{ind}$). Using the charge induced in the semiconductor space charge region $Q_{sc}$ and the charge induced in the semiconductor $Q_{ind}$, (which is comprised of the changes in the semiconductor space charge and surface charge) various parameters such as surface state density and oxide/insulator charge can be easily and reliable determined.

An apparatus for making ac surface photovoltage measurements of a specimen of semiconductor material under dc bias voltage conditions in accordance with the method of the present invention is described The apparatus includes a flexible reference electrode assembly. In one version, the flexible reference electrode assembly includes a reference electrode which is a coating on a film (i.e. a flexible thin sheet) of insulating material. When SPV measurements are being made, the reference electrode is held in close compliance with the surface of the specimen by pressure which is transmitted to the reference electrode through a fluid. In a modifications, the pressure is transmitted to the reference electrode through an elastomeric button. Several embodiments of the button are disclosed. In another version the flexible reference electrode assembly includes a reference electrode which is a coating formed on a rigid plate which in turn is mounted on a flexible supporting frame. When the SPV measurements are being made, the reference electrode is brought into close compliance with the specimen through a magnetic field produced by an electromagnet. In another version, the flexible reference electrode assembly includes a reference electrode which is a coating formed on a rigid plate which in turn is mounted on a flexible supporting frame, the frame having a plurality of piezoelectric actuators. When the SPV measurements are being made, the reference electrode is maintained at a precise distance from the specimen and locally parallel to the specimen by selectively energizing the piezoelectric actuators.

The reference electrode is made much smaller in size than the specimen.

A guard electrode is included for limiting fringing field problems in the application of the bias field, for defining more clearly the area of the specimen from which the SPV signals are received and for making easier the calibration of the surface space charge capacitance relationship to the photovoltage signals detected.

Various features and advantages will appear from the description to follow. In the description, reference is made to the accompanying drawing which forms a part thereof, and in which is shown by way of illustration, specific embodiments for practicing the invention. These embodiments will be described in sufficient detail to enable those skilled in the art to practice the invention, and it is to be understood that other embodiments may be utilized and that structural changes may be made without departing from the scope of the invention. The following detailed description is, therefore, not to be taken in a limiting sense, and the scope of the present invention is defined by the appended claims.

BRIEF DESCRIPTION OF THE DRAWINGS

In the drawings wherein like reference numerals represent like parts.

Fig. 1 is a schematic of an apparatus constructed according to the teachings of the present invention;

Fig. 2 is a schematic of a modification of the holder portion of the apparatus shown in Fig. 1;

Fig. 3 is a schematic illustration of an apparatus for making ac surface photovoltage measurements of a specimen of semiconductor material under bias voltage conditions constructed according to the teachings of the present invention;

Fig. 4 is a schematic of the light source, the back electrode and the reference electrode assembly in the apparatus shown in Fig. 3;

Fig. 5 is a perspective view of the diaphragm in the reference electrode assembly shown in Fig. 4;

Fig. 6 is a modification of the diaphragm shown in Fig. 3.

Fig. 7 is an electrical schematic useful in understanding how the guard electrode and the reference electrode in the diaphragm shown in Fig. 5 are interconnected;

Fig. 8 is a section view of a modification of the diaphragm shown in Fig. 5;

Fig. 9 is an exploded perspective view of the diaphragm shown in Fig. 8;

Fig. 10 is a view of a modification of the diaphragm shown in Fig. 9;

Fig. 11 is a section view of another modification of the diaphragm shown in Fig. 8;

Fig. 12 is a schematic illustration of a modification of the embodiment shown in Fig. 4;

Fig. 13 is an exploded perspective view of the diaphragm and the elastomeric button in the reference electrode assembly shown in Fig. 12.

Fig. 14 is a section view of a modification of the embodiment shown in Fig. 12;

Fig. 15 is an exploded perspective view of the button and diaphragm portions of the reference electrode probe assembly shown in Fig. 14;

Fig. 16 is a schematic representation of another modification of the arrangement shown in Fig. 3 for picking up the SPV signals and supporting the specimen;

Fig. 17 is a schematic representation of another arrangement for illuminating the specimen, picking up the SPV signals and supporting the specimen;

Fig. 18 is a schematic representation of another arrangement for illuminating the specimen, picking up the SPV signals and supporting the specimen;

Fig. 19 is a schematic of the reference electode assembly in the apparatus in Fig. 18;

Fig. 20 is a schematic representation of another arrangement for illuminating the specimen, supporting the specimen and picking up the SPV signals;

Fig. 21 is a schematic representation of another version of the reference electrode assembly according to this invention;

Fig. 22 is a plan view taken from the bottom of the glass plate shown in Fig. 21;

Fig. 23 is a simplified perspective view of an implementation of an apparatus constructed according to this invention;

Fig. 24 is a side elevation view of the apparatus shown in Fig. 23.

Fig. 25 is a section view of another modification of the embodiment shown in Fig. 12;

Fig. 26 is an exploded perspective view of portions of the reference electrode probe assembly shown in Fig. 25; and

Fig. 27 is a plan view taken from the bottom of the support shown in Fig. 25.

Fig. 28 is a graph of the reciprocal of the space charge capacitance ($l/C_{sc}$) versus induced charge density ($q/cm^2$), for a sample semiconductor; and

Fig. 29 is a graph of surface state density versus energy in the band gap for a sample semiconductor;

DETAILED DESCRIPTION OF PREFERRED EMBODIMENTS

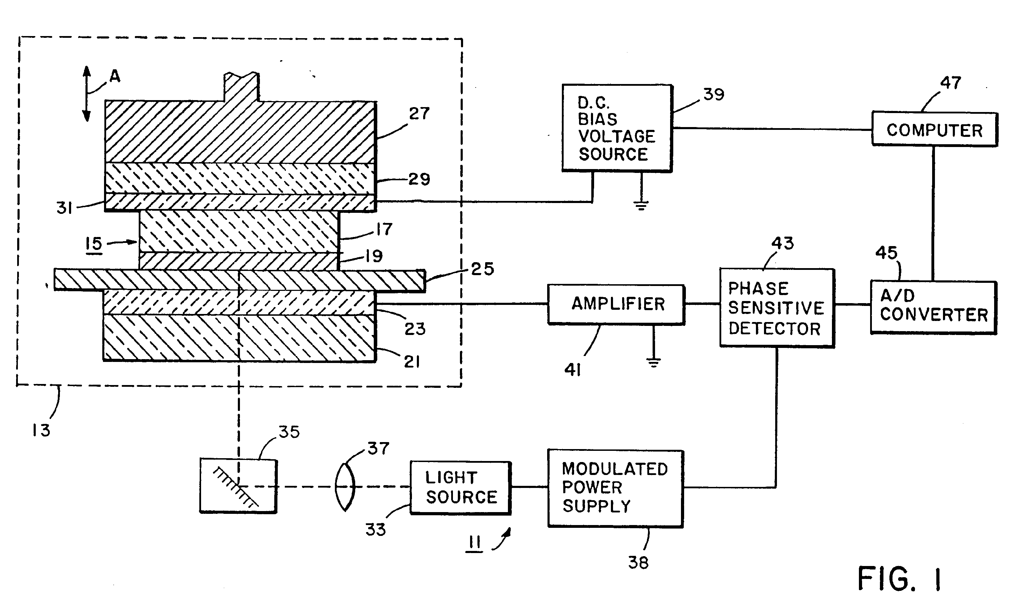

Referring now to the drawings, there is shown in Fig. 1 a simplified schematic illustration of an apparatus for use in the characterization of a semiconductor constructed according to this invention, the apparatus being identified by reference numeral 11.

Apparatus 11 includes a holder 13 for holding the specimen being examined, the specimen being identified by reference numeral 15. For illustrative purposes, the specimen 15 under examination is a wafer 17 of silicon having an oxide coating 19 (i.e.$SiO_2$) on its front surface.

Holder 13 includes a substrate 21, a reference electrode 23, an insulator 25, a mechanical press 27, a rubber pad 29 and a back contact 31. Substrate 21 which serves as a base is made of glass or other transparent material having good optical quality. Reference electrode 23 is a conductive and transparent coating, such as indium-tin-oxide, which is formed on substrate 21 by any suitable means such as deposition and annealing. Insulator 25 is a sheet of mylar or other equivalent material such as teflon. Rubber pad 29 is fixed to mechanical press 27 by glue, cement or other suitable means. Back contact 31 is a sheet of conductive material, such as aluminum foil is fixedly attached rubber pad 29 by glue, cement or other suitable means.

Substrate 21 is stationary while press 27 can be moved back and forth from substrate 21 in the direction shown by arrows A.

In use, insulator 25 is placed on reference electrode 23, and specimen 15 positioned on insulator 25 as shown with its oxide coating 19 in contact with insulator 25. Press 27 is then moved toward specimen 15 so that back contact 31 is pressed up against the back surface of specimen 15, as shown. As can be appreciated, insulator 25 prevents leakage between the specimen and reference electrode 23. In addition because specimen 15 is pressed up against reference electrode 23, but separated therefrom by insulator 25, reference electrode 23 and the specimen 15 are maintained parallel to each other.

If the specimen to be examined is an MIS device or an MOS device instead of a wafer, then insulator 25 and reference electrode 23 are eliminated and the specimen placed in holder 13 with the metal layer portion facing substrate 21. In this arrangement, the metal layer portion serves as the reference electrode.

If desired, an insulator made of mylar or other dielectric material may be placed between back contact 31 and the back surface of the specimen 15, for protective purposes.

In the operation of apparatus 11, a collimated beam of light emitted from a source 33 is deflected off of a scanning galvanometer 35 and brought to focus by a lens 37 at the front surface of specimen 15. Source 33 is driven by a modulated power supply 38 so that the output beam that is emitted from source 33 is intensity modulated. Source 33 may comprise a light emitting diode and a collimator. A variable bias voltage is applied to back contact 31 from a DC voltage source 39, which may be a voltage ramp generator or an amplifier with the ramp supplied by a computer 47. The ac photovoltage signal developed across the surface of specimen 15 upon illumination is capacitively picked up by reference electrode 23 and fed into an amplifier 41. The output of amplifier 41 is fed into a phase sensitive detector 43 which is set up so that at deep depletion or inversion one component (i.e. the real component) of the photovoltage signal (SPV) vanishes and the other component (i.e. the imaginary component) which is phase shifted by ninety degrees relative to the impinging light beams (see E. Kamieniecki paper noted above in the journal of applied Physics date Nov. 1983) reaches a maximum. The output of phase sensitive detector 43 is fed into an analog to digital converter (A/D) 45 whose output is fed into computer 47 for processing.

The polarity (i.e. positive or negative) of the surface photovoltage signal (SPV), and especially, the imaginary component thereof, depends on the doping type (p or n) of the specimen and can therefore be used to determine the doping type of the specimen. The change in polarity of the SPV signal results from the difference in the sign of the surface potential barrier under depletion conditions for n and p type semiconductors.

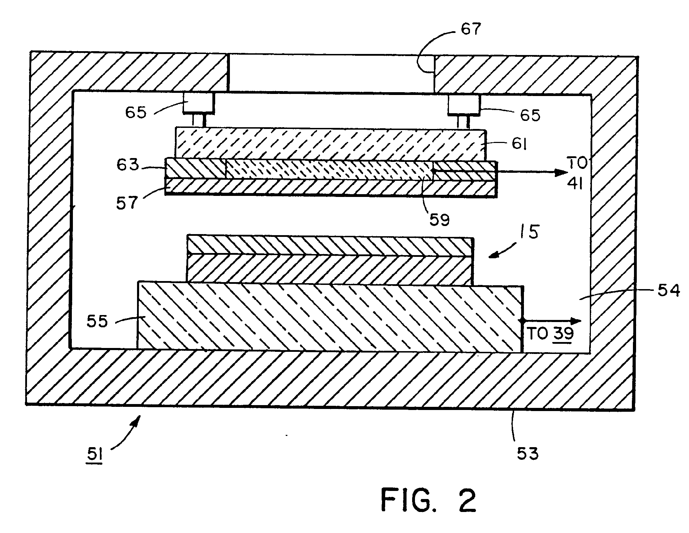

In Fig. 2 there is shown another embodiment of the holder portion of the apparatus, the holder being identified by reference numeral 51. In this arrangement the specimen does not actually come into contact with the insulator separating the specimen from the reference electrode.

Holder 51 includes a support frame 53, which defines a chamber 54, a vacuum chuck 55, an insulator 57, a reference electrode 59, a substrate 61, a plurality of position sensors 63 and a plurality of positioning devices 65.

Support frame 53 includes an opening 67 for the illuminating light beam. Vacuum chuck 55 also serves as a back contact. Specimen 15, as can be seen, is seated on vacuum chuck 55. Insulator 57 may either be sheet of mylar or teflon which is fixed to reference electrode 59 by any suitable means or an insulative coating such as a polyimide which is formed by any suitable means on reference electrode 59. An example of a polyimide is Pyralin made by Dupont. Reference electrode 59 is a conductive and transparent coating which is formed on substrate 61 by any suitable means. Substrate 61 is made of transparent material such as glass. The position sensors 63, which may be capacitive or optical, are attached to substrate 61 and are used to determine the geometric relation between the reference electrode 59 and the semiconductor 15 being examined. The information from sensors 63 is fed into computer 47 and used to control the positioning devices 65 which may be dc motors or piezoelectric translators. Positioning devices 65 are fixed to substrate 61 and are used to angularly move substrate 61 so as to maintain reference electrode 59 and the (front surface of) semiconductor 15 in parallel relationship.

As can be seen, there is a gap between insulator 57 and semiconductor 15. The gap is about 1μm. Since specimen 15 is held on chuck 55 by a vacuum it will not bend or curl as a result of any electrostatic attraction with the reference electrode 59. Also, by using positioning sensors 63 and positioning devices 65, reference electrode 59 and specimen 15 can be adjusted to the desired separation and maintained parallel. In addition, insulator 57 prevents leakage between reference electrode 59 and the semiconductor 15.

Chamber 54 is preferably flushed with an inert gas such as argon or nitrogen to prevent contamination of the sample.

Apparatus as shown in Fig. 1 has been constructed in the laboratory. Recurrent problems with the apparatus as so constructed have been caused by the conflicting need to (i) apply sufficient pressure to hold the insulator motionless during the sweep of the bias field voltage and maintain the reference electrode in close compliance (i.e. locally parallel relationship) with the semiconductor and (ii) avoid high voltage break down of the insulator which may become damaged by the physical holding forces and dust particles and/or breakage or contamination of the semiconductor itself. Insulator motion during the bias sweep is caused by the electrostatic forces produced by the bias field. The forces may cause the insulator to move, changing the distance between the reference electrode and the semiconductor during the bias sweep. Changes in the distance between the reference electrode and the semiconductor will cause local variations in the coupling capacitance (i.e. the capacitance between the reference electrode and the specimen) and therefore disturb output photovoltage signal. Such changes may also cause modulation of the optical interference fringes in the narrow gaps between the insulator, the specimen and reference electrode. This light intensity modulation can distort the results and render it uninterpretable.

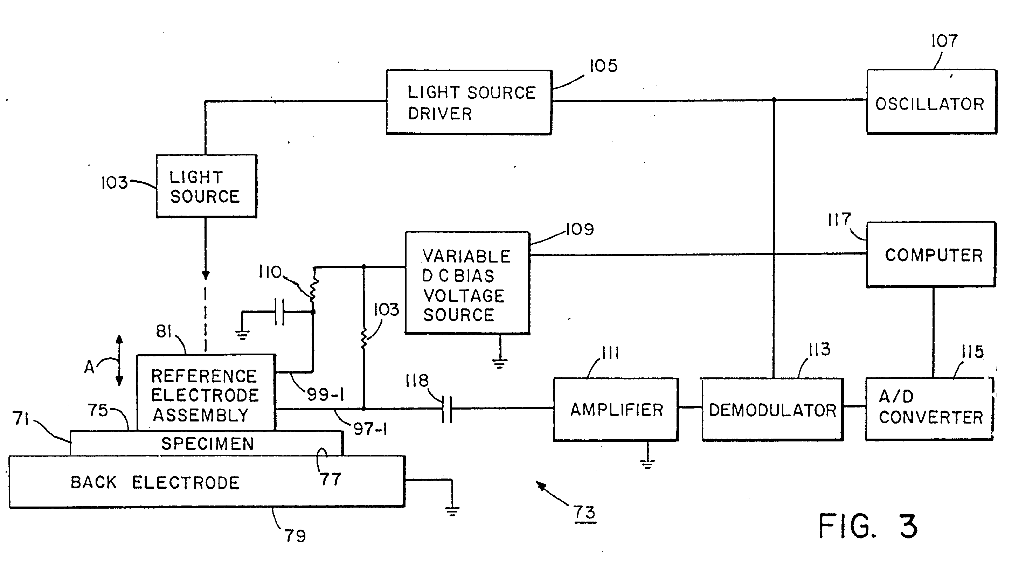

Referring now to Fig. 3 there is illustrated a simplified schematic of another apparatus constructed according to this invention for making ac surface photovoltage measurements of a specimen of semiconductor material. In the illustration, the specimen of semiconductor material is identified by reference numeral 71 and the apparatus is identified by reference numeral 73. As can be seen, in the Fig. 3 apparatus specimen 71 is illuminated from the back rather than the front as in the Figure 1 apparatus.

Specimen 71 has two major surfaces 75 and 77, respectively, surface 75 being the surface under testing. Specimen 71 may comprise a slab of silicon in a wafer configuration. An oxide coating (not shown) may be on surface 75.

Apparatus 73 includes a back electrode 79 and a capacitive pickup type reference electrode assembly 81. Back electrode 79, which also serves as a base or support for specimen 71, is a rigid member made of a conductive metal, such as aluminum. As can be seen, specimen 71 is seated on back electrode 79 with surface 75 facing upward (at the top in Fig. 3) and surface 77 in contact with back electrode 79 (at the bottom in Fig. 3). Back electrode 79 is connected to ground. Back electrode 79 is stationary while reference electrode assembly 81 is movable vertically relative to back electrode 79, as shown by arrows A, so that it can be lowered into contact with specimen 71 for testing and then raised after the measurements have been taken. Alternatively, (not shown) reference electrode assembly 81 could be stationary and back electrode 79 movable vertically relative to reference electrode assembly 81.

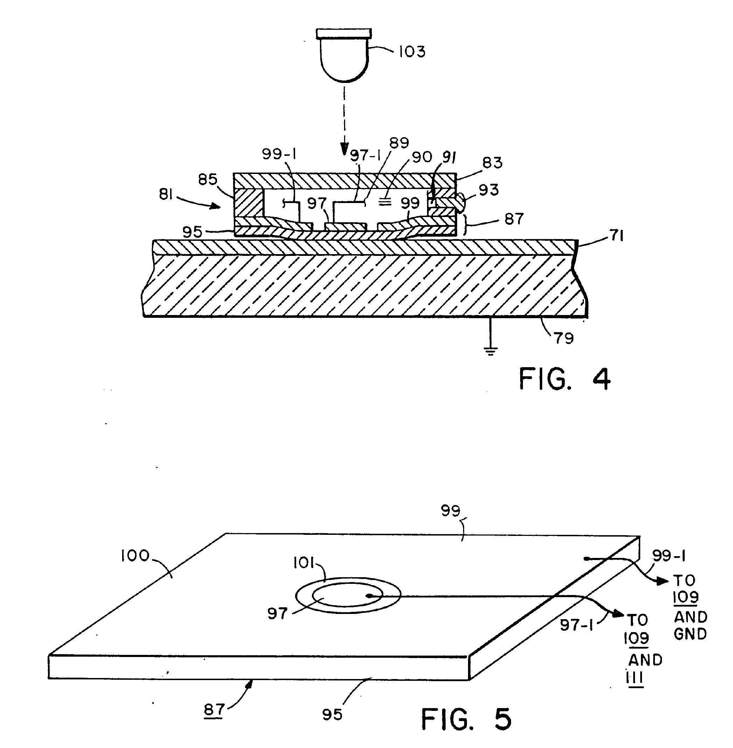

Reference electrode assembly 81, which is also shown in Fig. 4, includes a flat plate 83 of rigid transparent material, such as glass. An annularly shaped spacer 85 made of a rigid material is fixedly attached to the bottom side of flat plate 83, plate 83 and spacer 85 defining a frame. A flexible diaphragm 87 is fixedly attached to the bottom side of spacer 85, the area between diaphragm 87, spacer 85 and plate 83 constituting an air tight chamber 89. Chamber 89 is filled with a quantity of fluid 90, such as air, which is under pressure. A port 91, which is formed in spacer 85 and which is covered by a removable plug 93 permits access to chamber 89, when desired.

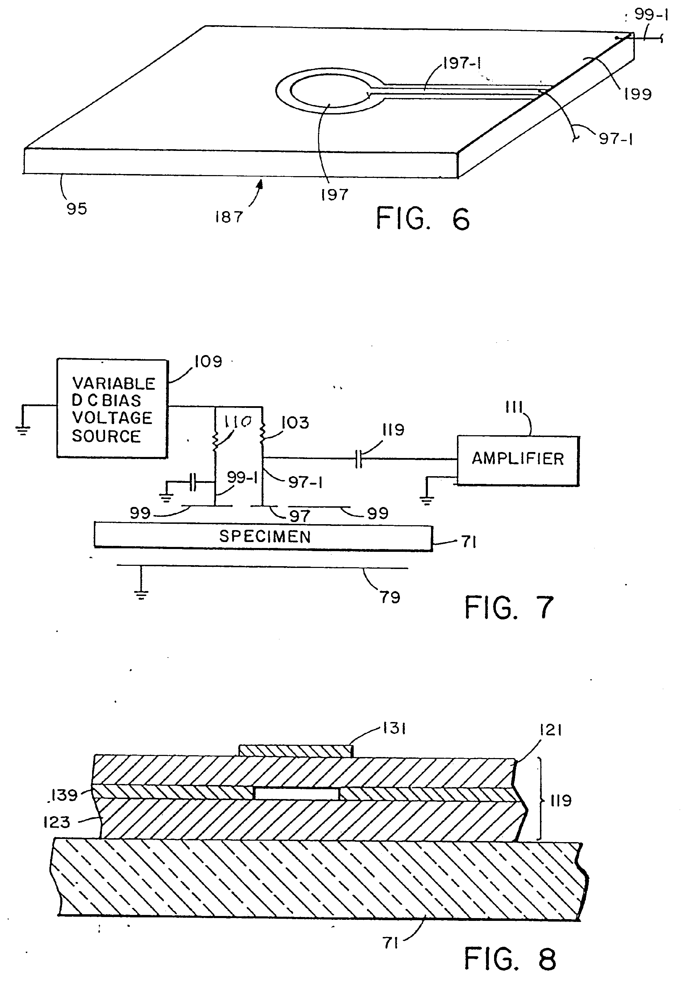

Diaphragm 87, which is also shown in Fig. 5, comprises a film 95 (i.e. a thin flexible sheet) of flexible transparent dielectric material, such as mylar. Sheet 95, which serves as an insulator, is smaller in size than specimen 71. A pair of coatings 97 and 99 of conductive material are formed on the top surface 100 of insulator 95 by any suitable means, such as deposition. Coating 97 is circular in shape and serves as a reference electrode. Coating 99 surrounds coating 97 but is separated from coating 97 by an annular shaped uncoated area 101 and serves as a guard electrode. Both coatings 97 and 99 may be made of aluminum. The thickness of coating 37 is such that it is transparent. Reference electrode 97 is much smaller than specimen 15. As can be seen, insulator 95 electrically separates coating 97 and 99 from specimen 71. A conductor 97-1 is connected to electrode 97 and a conductor 99-1 is connected to electrode 99. An alternative arrangement of diaphragm 87 is shown in Fig. 6 and is identified by reference numeral 187. Diaphragm 187 includes reference and guard electrodes 197 and 199, respectively which are formed on sheet 95. Reference electrode includes a thin stripe 197-1 which extends to the edge of diaphram 187 and coating 199 surrounds but is spaced from coating 197. Conductor 97-1 is attached to the outer end of strip 197-1.

Referring back to Fig. 3, apparatus 73 further includes a light source 103, a light source driver 105, an oscillator 107, a variable dc bias voltage source 109, an amplifier 111, a demodulator 113, an analog to digital A/D converter 115 and a computer 117.

Light source 103 is fixed in the x-y (i.e. horizontal) direction relative to reference electrode assembly 81 and positioned so that the light beam is vertically aligned with reference electrode 97.

Light source 103 is separate from reference electrode assembly 81, but may if desired be attached to reference electrode assembly 81 by a frame (not shown).

In using apparatus 73, specimen 15 is placed on back electrode 79 as shown. Reference electrode assembly 81 is then moved vertically down so that reference electrode 97 is in close proximity to specimen 71. Reference electrode assembly 81 is then pressed down against specimen 71 by any suitable external means (not shown) with sufficient pressure so that reference electrode 97 is in close compliance (i.e. parallel relationship) with surface 75 of specimen 71, the pressure being transmitted from plate 83 to reference electrode 97 through the fluid in chamber 89. Since reference electrode 97 is formed on the top surface of insulator 95 it does not actually come into contact with specimen but rather forms a capacitance type of pickup. A beam of light from source 103 is then directed through flexible reference electrode assembly 81 onto front surface 75 of specimen 71 to generate the SPV signals. As can be appreciated, the light beam from source 103 will pass through reference electrode 97 since it is transparent. Source 103, which may be a light emitting diode, is driven by light source driver 105 which modulates the light beam that is emitted. Light source driver 105 is driven by oscillator 107. A variable de bias voltage of from about 0 to about 500 volts is applied to reference electrodes 97 and 99 from variable dc bias voltage source 109, the voltage being applied through separation resistors 103 and 110, respectively. The ac photovoltage signals developed across the surface 75 of specimen 15 upon illumination as the bias voltage from source 109 is varied are capacitively picked up by reference electrode 97 and fed through an isolation capacitor 118 into amplifier 111. Signals picked up by guard electrode 99 are shunted to ground. As can be appreciated, guard electrode 99 serves to avoid fringing field problems in the application of the bias field and also serves to limit the area on surface 75 of specimen 15 that provides the SPV signal to reference electrode 97. The output of amplifier 111 is fed into demodulator 113. The output of demodulator 113 is fed into A/D converter 115 whose output is fed into computer 117. Bias voltage source 109 may be, for example, in the form of a voltage ramp generator or an amplifier with the ramp supplied by computer 117.

If desired, an insulator of appropriate material and thickness (not shown) may be placed between specimen 71 and back electrode 79 for protective purposes.

An electrical schematic showing how reference electrode 97 and guard electrode 99 are interconnected is shown in Fig. 7. As can be seen, guard electrode 99 is electrically isolated from reference electrode 97 but is at the same dc potential as reference electrode 97.

After the SPV measurements have been made, assembly 81 is raised.

Instead of having a fixed pressure inside chamber 89, a pump for selectively increasing the pressure could be connected to chamber 89. In this case, assembly 81 would be hrought close to specimen 71 and the pressure increased to push diaphragm 87 against specimen 71 to insure uniform compliance between electrode 97 and specimen 71 and then decreased after the testing has been completed.

The pickup arrangement shown in Fig. 3 for sensing the SPV signals has many advantages which are readily apparent.

For example, by making the reference electrode a flexible rather than a rigid type of structure, the reference electrode can be bent to conform to the shape of the specimen to achieve uniform compliance with the specimen rather than having to make the specimen conform to the shape of the reference electrode. Also, by making the reference electrode flexible, the pressure that must be applied to obtain close compliance between the reference electrode and the specimen is less than it would be if it were rigid. Also, if the pressure that must be applied to insure compliance between the reference electrode and specimen is reduced the likelyhood of damaging the specimen and/or the insulator on which the reference electrode is formed will be reduced.

By making the reference electrode smaller than the specimen, several benefits are also realized. First, and most important, since the SPV signal-to-noise (S/N) ratio depends mainly on the ratio of the mutual capacitance between the illuminated part of the specimen and the reference electrode and the total mutual capacitance between the specimen and the reference electrode, if the reference electrode is made smaller relative to the specimen and the size of the illuminating light beam is not changed, the SPV signal to noise ratio will be made larger. If amplifier 111 is a voltage amplifier then the S/N ratio will increase since the signal will increase and if amplifier 111 is a current amplifier the S/N ratio will increase since the noise will decrease. Also, if the reference electrode is reduced in size, the pressure needed to achieve compliance of the specimen to the reference electrode surface may be reduced. Also, by making the reference electrode smaller than the semiconductor, the insulator can also be made smaller and will consequently be easier to keep clean and dust free. Also, if the reference electrode is small relative to the specimen, then the corresponding insulator area exposed to high voltage stress will be reduced, thus minimizing the likelyhood of high voltage breakdown. Damage and contamination of the specimen will also be reduced. Also, if the SPV signal to noise ratio is increased, then the SPV signals can be measured for less time and the insulator will be less liable to high voltage breakdown. Furthermore, by making the reference electrode small, accommodation of the apparatus to specimens of various sizes is simpler. Also, by making the insulator smaller than the specimen, then only a portion of the specimen surface will actually be touched by the insulator at any one time.

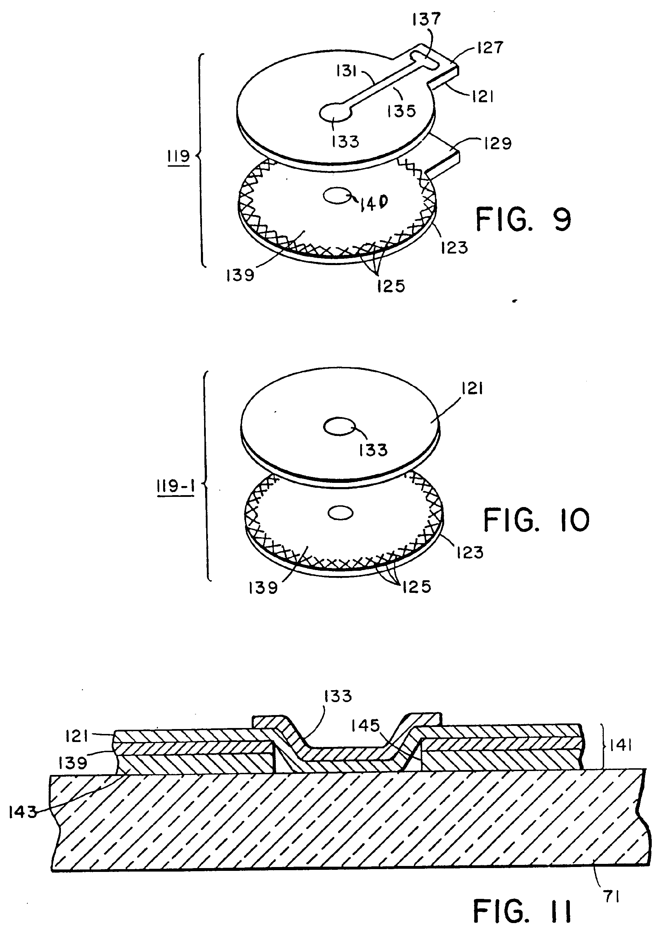

In Figs. 8 and 9 there is shown another modification of construction of diaphragm 87, the modification being identified by reference numeral 119. Also shown in Fig. 8 is specimen 71. As can be seen, diaphragm 119 comprises two substantially disc shaped sheets 121 and 123 of transparent, flexible, dielectric material instead of a single sheet as in diaphragm 87. Sheets 121 and 123 are stacked one on top of the other and fixedly secured around at their outer edges by an adhesive 125, such as glue. Each sheet 121, 123 includes a peripheral tab area, 127 and 129, respectively. Sheets 121 and 123 may be made of mylar or other equivalent material.

Sheet 121, which is the upper sheet, has a transparent conductive coating 131 on its top surface. Coating 131 is shaped to define a small circular area 133 at the center of the sheet which serves a reference electrode, a rectangular area 137 on tab 127 which serves as an electrical contact and a narrow strip 135 for connecting area 133 to area 135. Lower sheet 123 has a nontransparent conductive coating 139 which covers the entire top surface, including the tab area 129, except for a small circular area 140 at the center which is slightly smaller in size than area 133. Sheets 121 and 123 are stacked so that area 73 is in registration with area 140. Conductive coating 139 on sheet 123 serves as a guard electrode. Coatings 131 and 139 may both be aluminum. Coating 131 is of appropriate thickness so as to be transparent. As can be seen, reference electrode 133 is much smaller in size than specimen 15.

In Fig. 10 there is shown a modification 119-1 of diaphragm 119, the difference being that in diaphragm 119-1 the stripe 131 and the tab portions have been omitted.

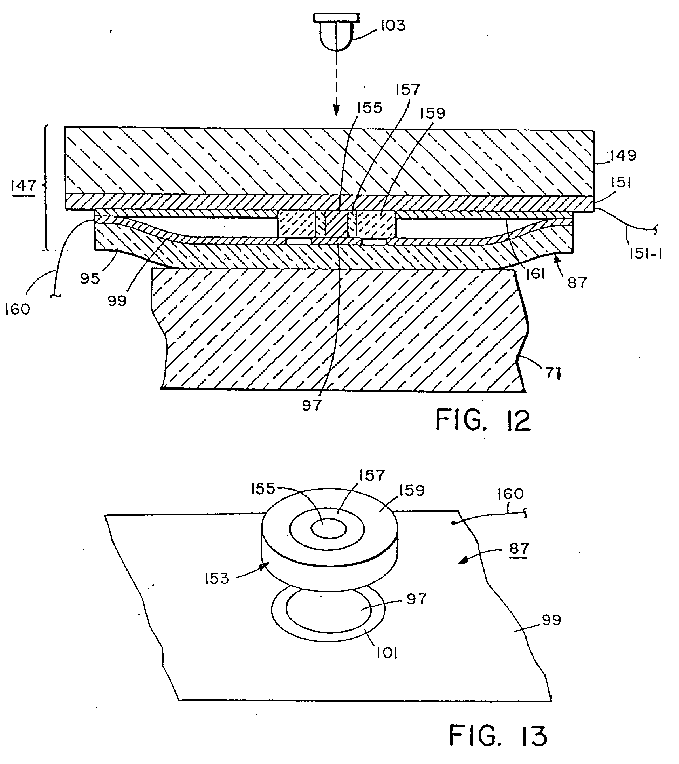

In Fig. 11 there is shown another modification of diaphragm 119, the modification being identified by reference numeral 141. Also shown in Fig. 11 is specimen 71. Diaphragm 141 differs from diaphragm 119 in that sheet 143, which is the bottom sheet, has a circular hole 145 at the center rather than a circularly shaped uncoated area at the center as with sheet 123. Except for hole 145, bottom sheet 143 is identical to bottom sheet 123. When diaphragm 141 is pushed in the direction of specimen 15, the center of top sheet 121 will partly extend through bottom sheet at hole 145, as shown. Diaphragm 119-1 may be modified in a similar manner.

In Fig. 12 there is shown a modification of reference electrode assembly 81 wherein pressure is transmitted to the diaphragm to maintain the reference electrode in compliance with the specimen through an elastomeric button rather than through a fluid, the modification being identified by reference numeral 147. Also shown in Fig. 12 are specimen 71 and light source 103.

Reference electrode assembly 147, parts of which are also shown in Fig. 13, includes a flat rigid transparent plate 149, such as glass, having a transparent conductive coating 151 on its bottom surface. Reference electrode assembly 147 also includes a flexible diaphragm 87. Diaphragm 87 is disposed below plate 149. A flexible and deformable button 153 is disposed between plate 149 and diaphragm 87. Button 153 includes an inner section 155 which is circular in cross-section and made of a transparent elastomer, an intermediate section 157 which is annularly shaped in cross section, surrounds inner section 155 and is made of an elastomer that is conductive and opaque and an outer section 159 which is ring shaped in cross section, surrounds intermediate section 157 and is made of an elastomer that is insulating and opaque. A conductor 151-1 is connected to coating 151. Intermediate section 157 of button 153 is in registration with reference electrode 97 on diaphragm 87. A conductor 160 is connected to coating 99 on diaphragm 87. An annular shaped spacer 161 made of nonconductive material, such as mylar, surrounds button 153. Spacer 161 is glued to coating 151 at the bottom of plate 149 and diaphragm 87 is glued to the bottom surface of spacer 161.

In use, reference electrode 97 is brought into uniform compliance with specimen 71 by applying pressure to plate 149, with the pressure being transmitted from plate 149 to diaphragm 87 through button 153.

As can be seen, button 153 serves simultaneously the four functions of a) transmitting uniform pressure to diaphragm 87 with minimal displacement b) allowing light to be passed to transparent reference electrode 97 c) confining the modulated light to a limited area of reference electrode 97 and d) providing an easy to assemble and low parasitic electrical connection to reference electrode 97 from coating 151.

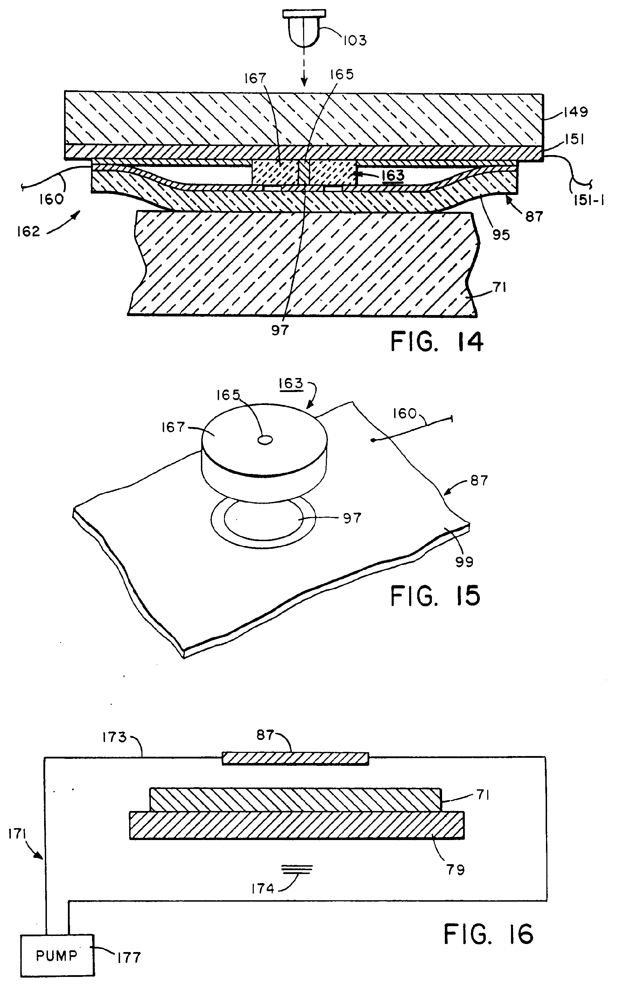

In Fig. 14 there is shown a modification of the reference electrode assembly shown in Fig. 12, the modification being identified by reference numeral 162. Also shown is specimen 71 and light source 103. As can be seen from Figs. 14 and 15, modification 162 includes a button 163 having an inner section 165 which is circular in cross-section and made of a conductive elastomer and an outer section 167 which is annular in cross-section. Outer section 167 surrounds inner section 165 and is made of a transparent, insulating elastomer. Button 163 is mounted in place between plate 149 and diaphragm 87. Inner section 165 is in contact with reference electrode 97 and serves to conduct the SPV signals from reference electrode 97 to coating 151. As can be appreciated, modification 162 differs from modification 147 only in the construction of the button. In modification 162 button 163 is made from only two different materials while in modification 147 button 153 is made from three different materials. A perspective view of button 163 and diaphragm 87 are shown in Fig. 15. Assembly 162 is used in the same way as assembly 147.

In Fig. 16 there is shown another arrangement for holding the specimen and maintaining uniform compliance as the SPV signals are being made, the arrangement being identified by reference numeral 171. Also shown in Fig. 16 is a specimen 71. As can be seen, specimen 71 is seated on a back electrode 79 which is located inside a chamber 173 filled with a fluid 174 such as air. An outlet on chamber 173 is connected to a vacuum pump 177 which is controlled by computer 117. Chamber 173 includes the diaphragm 87 which is formed as a window on chamber 173. In use, when SPV measurements are to be made, a negative pressure is created inside chamber 173 by pump 177, the negative pressure pulling diaphragm in toward specimen 71 so that reference electrode 97 is brought into contact with specimen 71 and held in uniform compliance.

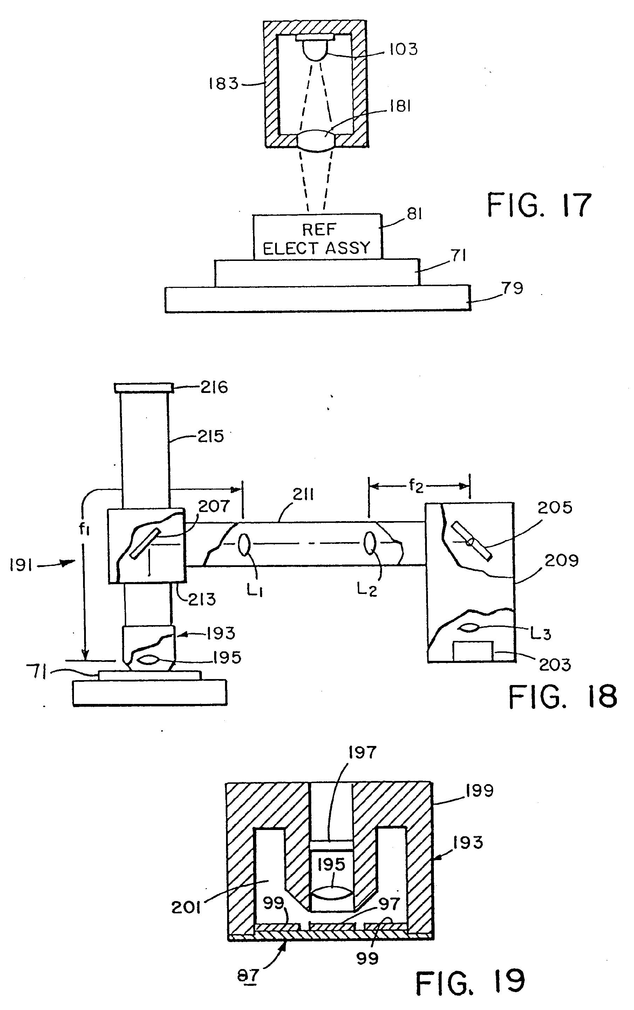

In Fig. 17 there is shown another arrangement for illuminating the specimen and for picking up the SPV signals and supporting the specimen during the measurement process. A light source 103 and a focusing lens 181 are fixedly mounted in a frame 183. Frame 183 is fixedly positioned (by means not shown) in the Z direction at a distance so that light from source 103 is brought to focus at specimen 71 and is movable in the x and y directions (by any suitable means, not shown) so that the light spot from source 103 can be made to scan across the portion of specimen 15 adjacent reference electrode 97 and thus illuminate a very small area at a time. Specimen 71 is seated on a support 79.

In Fig. 18 there is shown another arrangement for illuminating the specimen and for sensing the SPV signals and supporting the specimen during the measurement process, the arrangement being identified by reference numeral 191. System 191 include a reference electrode assembly 193 which is also shown separately in Fig. 19. As can be seen in Fig. 19, a focusing lens 195, a diaphragm 87 and a window 197 are mounted on a common frame 199 which is shaped to define an air tight chamber 201 which is under pressure. Returning back to Fig. 18, a beam of light from a source 203 is collimated by a lens $L_3$, deflected off a scanning mirror 205 driven by any mechanical means (not shown), passed through a pair of lens $L_1$ and $L_2$ which are spaced as shown, then deflected off a semitransparent mirror 207 into reference electrode assembly 193 where it is brought to focus as a small spot on specimen 71. Since mirror 205 is scanning, the spot of light is not stationary but rather will scan over the surface of specimen 71. Source 203, lens $L_3$ and mirror 205 are mounted in a housing 209. Lenses $L_1$ and $L_2$ are mounted in housing 211. Mirror 207 is mounted in a housing 213. Housing sections 209, 211 and 213 are fixed relative to each other. A housing 215 which is tubular in shape and includes assembly 193, which functions as a microscope objective, at one end an eyepiece 216 at the other end is movable vertically relative to housing 211 to permit assembly 193 to be brought into contact with specimen 71. Light source 203 may comprise an LED and a beam expander .

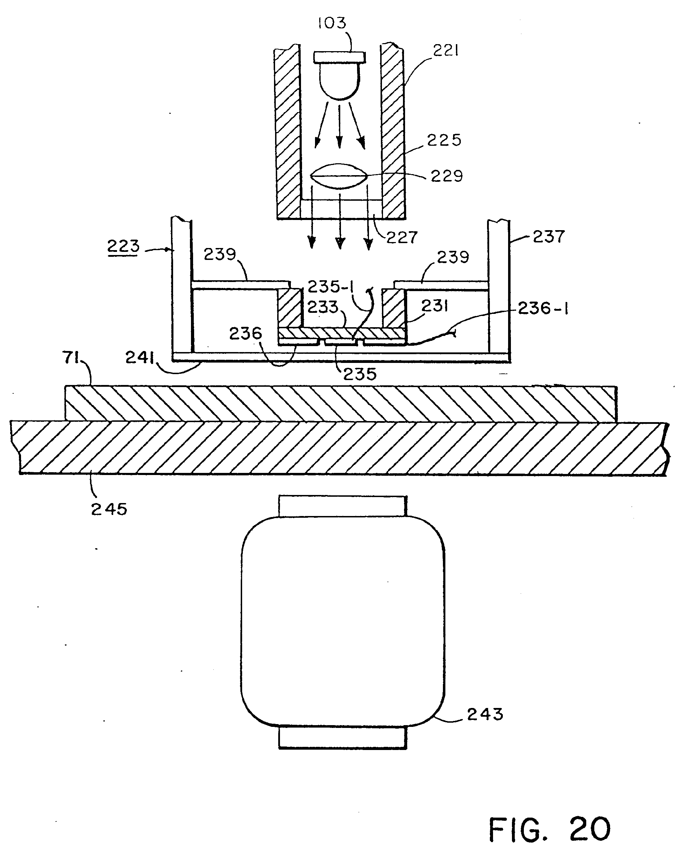

In Fig. 20 there is shown another arrangement for illuminating the specimen along with another arrangement for sensing the SPV signals and supporting the specimen during the measurement process. Also shown is specimen 71. There is a light source assembly 221 and a reference electrode assembly 223. Light source assembly 221 includes an electrically shielded housing 225 having a window 227, a light source 103, and a collimating lens 229 for collimating the beam of light from source 103 which are fixedly mounted (by means not shown) in housing 225. Reference electrode assembly 223 includes a ring 231 made of iron or other material which is conductive and magnetic. A glass plate 233 is glued to ring 231. Coatings defining a reference electrode 235 and a guard electrode 236 are deposited on the bottom surface of plate 233. Ring 231 is fixedly attached to a frame 237 by a flexible annularly shaped suspension 239 made of a nonmagnetic material. A sheet of flexible transparent dielectric material 241, such as mylar, is attached to frame 237 below plate 238.

An electromagnet 243 is disposed underneath a support 245. Support 245 is made of any rigid, conductive, nonmagnetic material, such as aluminum.

Specimen 71 is seated on support 245. Conductors 235-1 and 236-1 are attached to electrodes 235 and 236, respectively. In use, reference electrode assembly 223 is brought close to specimen 71. Electromagnet 243 is then energized, creating a magnetic field which pulls ring 231 downward by magnetic attraction, carrying with it plate 233 and sheet 241. As a result, plate 233 and sheet 241 are pressed evenly and controllably against specimen 71, sheet 241 electrically separating plate 133 from specimen 71.

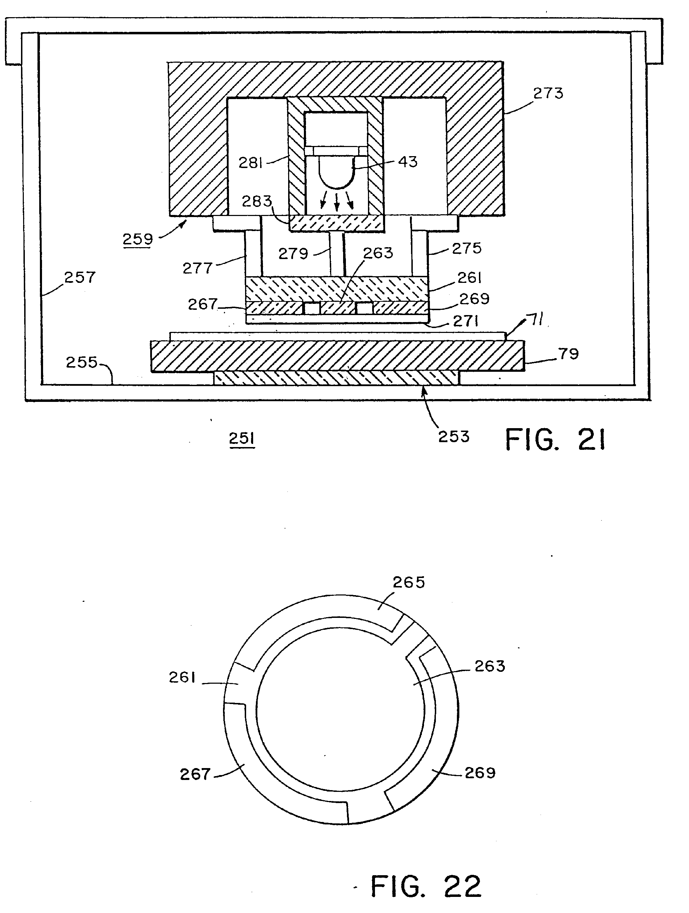

In Fig. 21 there is shown another arrangement for illuminating the specimen and for sensing the SPV signals and supporting the specimen during the measurement process, the arrangement being designated by reference numeral 251.

A support plate 79 is mounted on an insulator 253 which is made of rigid material such as glass. Insulator 253 is seated on the floor 255 of a gas tight enclosure 257 which is flushed periodically with an inert gas. The specimen 71 being examined is seated on support plate 79. A reference electrode assembly 259 is also disposed in enclosure 257. Reference electrode assembly 259 includes a rigid transparent plate 261 of nonconductive material such as glass which is conductively coated on its bottom surface. The conductive coating is shaped, as shown in Fig. 22, to define a central pickup area 263 and three edge pickup areas 265, 267 and 269. The coating making up area 263 is transparent. Central pickup area 263 serves as a reference electrode while edge areas 265, 267 and 269 serve as pickups to sense the distance from the bottom of plate 261 to specimen 71. A sheet 271 of transparent dielectric material, such as mylar, which serves as an insulator is attached to the bottom of plate 261. Alternately, the insulator could be a coating on plate 261. Plate 261 is attached to a support 273 by a set of three piezoelectric actuators 275, 277 and 279 which are used to maintain the desired separation and parallelism between reference electrode 263 and specimen 71. Support 273 is movably mounted (by means not shown) inside enclosure 257 so that reference electrode 263 can be placed over any desired area on specimen 15. A light source 103 for illuminating specimen 15 is fixedly mounted on support 273 above plate 261. Light source 103 is enclosed in an electrically shielded housing 281 having a window 283 at the bottom. When SPV measurements are being made, insulator 271 is not in contact with specimen 71 but, rather, is spaced above specimen 71 a predetermined distance. Pickups 265, 267 and 269 are used to sense the distance between plate 261 and specimen 71 and actuators 275, 277 and 279 are used to maintain the distance and keep reference electrode 263 (locally) parallel with specimen 71.

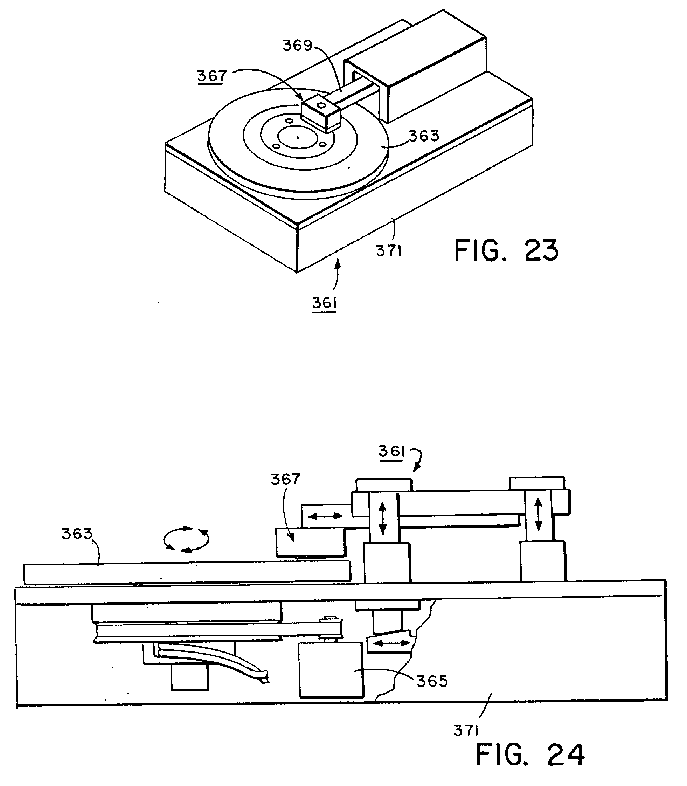

In Figs. 23 and 24 there are shown simplified representations of an apparatus 361 for implementing this invention. Apparatus 361 includes a turntable 363 which is driven by a motor 365. Turntable 365 is made of conductive material. A probe assembly 367 is attached to an arm 369 which is movable in the x and z directions. The electronics (including a computer) is disposed in a base housing 371. Probe assembly 367 may comprise reference electrode assembly 81 and light source 103.

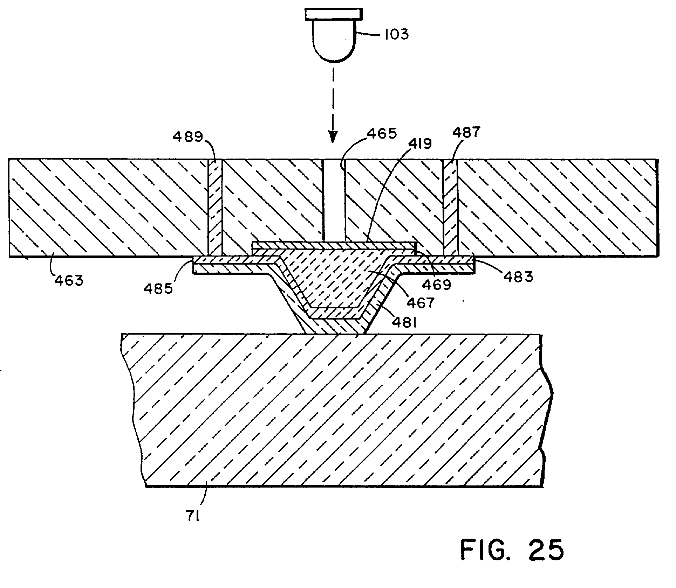

Referring now to Fig. 25, there is shown another modification of the reference electrode assembly shown in Fig. 12, the modification being identified by reference numeral 461.

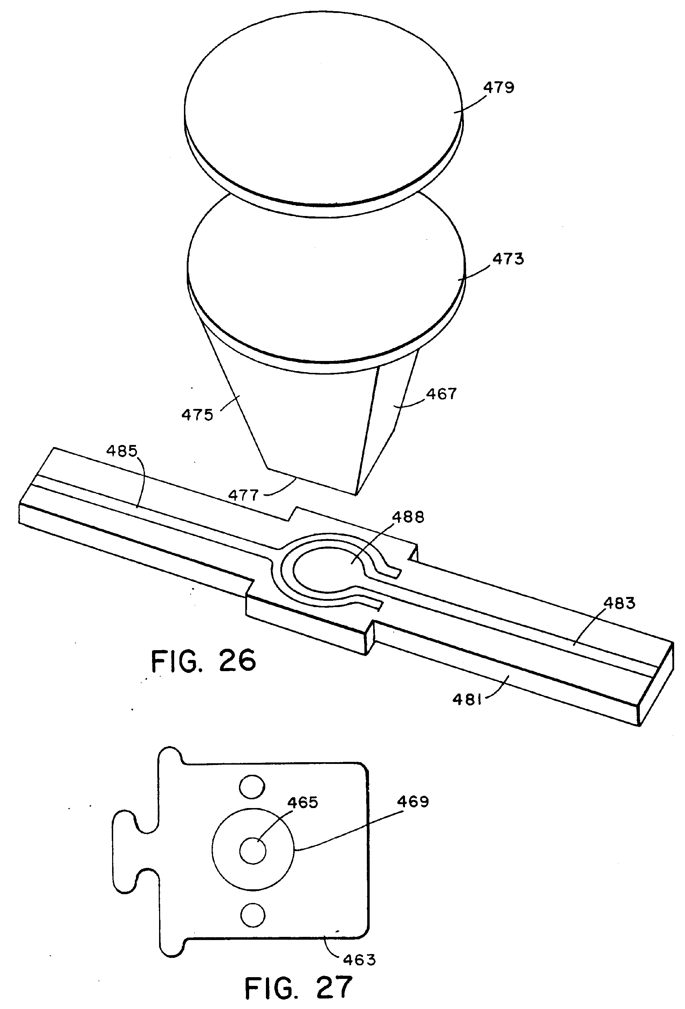

Reference electrode assembly 461, parts of which are also shown in Figs. 26 and 27, includes a flat plate 463 made of bakelite or other rigid nonconductive material. A hole 465 is provided in plate 463 to allow light from source 103 to pass through to specimen 71. If plate 463 is made of a rigid nonconductive material which is transparent rather than opaque as is the case with bakelite, then hole 465 is not necessary and may be omitted. A flexible and deformable button 467 is fixedly secured by glue, not shown, in a recess 469 formed on the bottom side of plate 463. Button 467 is made of a transparent insulating elastomer, such as silicone rubber and includes a top 473 which is substantially circular in cross-sectional shape, a main body portion 475 which is in the shape of a part of an inverted pyramid and a bottom 477 which is rectangular in shape. A flat rigid disc 479 of transparent material, such as Lexan, is positioned between plate 463 and button 467 to prevent button 467 from extending into hole 465 when plate 463 is pushed downward, (by external means, not shown) toward specimen 71 as will hereinafter be described. A film 481, made of a flexible insulating material, such as Mylar is fixedly attached to plate 463 and to button 467 by glue (not shown). First and second conductive coatings 483 and 485, respectively are formed on the top side 487 of film 481. First coating 483 is transparent, is shaped to include an end portion 488 which is positioned underneath the bottom 477 of button 467 and serves as a reference electrode. Coating 485 is spaced from coating 483, is shaped to surround at least end portion 488 of coating 483 and serves as a guard electrode. Both coatings may be made of gold. A pair of electrical contacts 487 and 489 are press fit into openings formed in plate 463, contact 487 being electrically coupled to coating 483 and contact 489 being electrically coupled to coating 485.

In use, reference electrode 488 is brought into uniform compliance with specimen 71 over the area underneath bottom side 477 by applying pressure to plate 463 from an external source, the pressure being transmitted from plate 463 to film 481 through sheet 419 and button 467.

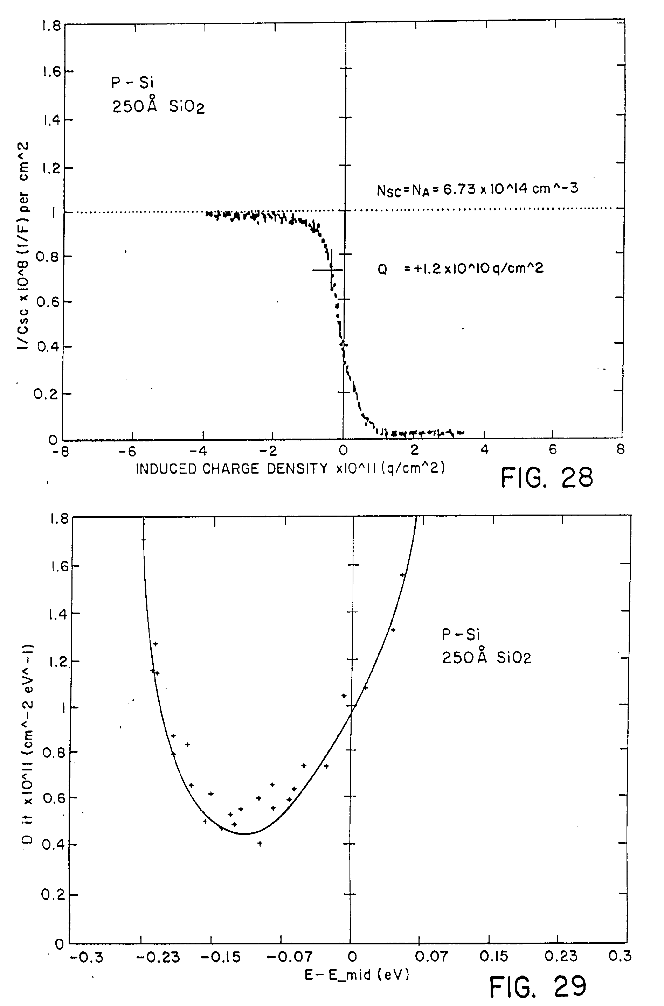

The results of the surface photovoltage (SPV) measurements for a region of specimen actually examined are presented in the graph shown in Fig. 28 as a dependance of the reciprocal of the space-charge capacitance. $I/C_{sc}$ versus the charge induced in the semiconductor specimen $Q_{ind}$ due to the application of the external DC bias voltage ($V_g$).

The space charge capacitance ($C_{sc}$) is obtained using the equation $\delta V_s = \frac{\phi(I - R)}{Kf} qC_{sc}^{-1}$ noted above.

$Q_{ind}$ can be determined by measuring the capacitance, ($C_i$), between the specimen and the reference electrode using a conventional capacitance meter and then multiplying the capacitance ($C_i$) by the externally applied dc bias voltage ($V_g$), as shown in the equation below:

$$Q_{ind} = C_i \times V_g$$

The induced charge ($Q_{ind}$) can be also be determined by measuring and integrating directly the current charging specimen/reference electrode capacitance. The results shown in the graph in Fig. 28 are for a wafer of p-type silicon ($S_i$) coated by thermal oxidation with a 250A thick layer of $SiO_2$.

The graph in Fig. 28 shows that a plot of $I/C_{sc}$ versus $Q_{ind}$ saturates at high $I/C_{sc}$ values. This saturation is known to correspond to a minimum space-charge capacitance related to a maximum depletion width. The limitation on the maximum value of the depletion-layer width is associated with occurance of the strong inversion at the semiconductor surface. This effect in relation to the conventional capacitance measurements is described in chapter 7 section 7.2.2 of the book "Physics of Semiconductor Devices" by S.M. Sze (John Wiley & Sons Inc., New York 1981, second edition) and for ac surface photovoltage in the article by R.S. Nakhmanson entitled "Frequency dependence of the photo-emf of strongly inverted Ge and Si MIS structures -I, Theory" published in Solid-State Electronics Vol 18, 1975, pages 617-626. Inversion discussed in this paper was actually induced due to the built-in charge (charge in the insulator).

The method of determining of the doping concentration according to this invention will now be explained.

The maximum value of $l/C_{sc}$ is proportional to the maximum depletion layer width, Wm, by the equation $(l/C_{sc})_{max} = W_m/\epsilon_s$ where $\epsilon_s$ is the permittivity of the semiconductor. The dependence of $W_m$ and hence $(l/C_{sc})_{max}$ versus doping concentration is discussed for different materials including silicon in Chapter 7 section 7.2.2 of the book "Physics of Semiconductor Devices" by S.M. Sze, John Wiley and Sons Inc., New York 1981, second edition (eq. 28) This relationship may therefore be used to determine doping concentration (in the region adjacent to the surface) of the semiconductor specimen even if the specimen is coated with a dielectric film.

The method of determining the surface (interface) state density according to this invention will now be explained.

Under depletion conditions, a change in the dc bias voltage and hence a change of the surface potential leads not only to a change in the semiconductor space charge $Q_{sc}$ (used for determination of the doping concentration) but also to a change of the surface (interface) state charge. Therefore a change of the charge induced in the semiconductor is due to the change of the semiconductor space charge $\Delta Q_{sc}$ and change of the surface (interface) state charge $\Delta Q_{ss}$.
$\Delta Q_{ind} = \Delta Q_{sc} + \Delta Q_{ss}$. This relation may be used to determine surface state density. $\Delta Q_{sc}$ can be determined from the change in the value of $l/C_{sc}$, using the equation $\Delta Q_{sc} = q\,N_{sc}\Delta W$, where $N_{sc}$ is the average doping concentration in the space charge region (which can be determined from $(l/C_{sc})_{max}$), $\Delta W$ is the change in the width of the depletion layer, $\Delta w = \epsilon_s \times \Delta(l/C_{sc})$, and q is an elementary charge. The change of charge in the surface states $\Delta Q_{ss} = \Delta Q_{ind} - \Delta Q_{sc}$. The surface potential, $V_s$, can be determined from the measured value of $l/C_{sc}$ using the equation: $V_s = -1/2\, q\,\epsilon_s N_{sc}(l/C_{s2})^2$. Hence the surface state density in the range of surface potentials from $V_{s1}$ to $V_{s2}$ differing by $\Delta V_s$ is,

$$D_{lt} = \Delta Q_{ss}/q\Delta V_s$$

The energy levels of these states can be calculated knowing the surface potential and the Fermi level (see e.g. Sze book noted above).

It should be noted that determination of the surface state density from the SPV method according to this invention is more accurate than from the capacitance/conductance measurements because of the substantial simplification of the equivalent circuit as discussed by Emil Kamieniecki in the article dated Nov., 1983 noted above. The interface state density for the sample plotted in Fig. 28 is shown in Fig. 29.

The method of determining the oxide/insulator charge (charge in the dielectric film such as an oxide) according to this invention will not be explained.

In the absence of the external bias voltage, the semiconductor/interface/oxide (insulator) system is neutral. Since the reference electrode is far away its disturbance can be neglected. Therefore, $Q_{ox} = -Q_{sc}(V_g=0) - Q_{ss}(V_g = 0)$

At some bias voltage $V_g$ the charge induced in the semiconductor/insulator (oxide) system is given by the equation:
$Q_{ind} = [Q_{sc} - Q_{sc}(V_g = 0)] + Q_{ss} - Q_{ss}(V_g = 0)]$, where $Q_{ind}$, $Q_{sc}$ and $Q_{ss}$ are the values at the bias voltage, and it is assumed that the total charge in the oxide is not changing due to external voltage (charge may move in the insulator/oxide- mobile charge, but may not be injected; if it is injected from the semiconductor then this change is attributed to charging of the surface states) From the above equations.

$$Q_{ox} = Q_{ind} - Q_{sc} - Q_{ss}$$

The bias voltage can be selected for instance in such a way that Fermi Level coincides with the middle of the band gap or minimum in the density of the surface state (see e.g. Sze book). This can be realized by determining surface potential corresponding to the value $q*abs(V_s) = E_{G/2} - E_F$, where $E_G$ is the bandgap of the semiconductor $E_F$ is the absolute value of the Fermi energy related to the appropriate band edge (conduction band for n-type, valence band for p-type ): from that we can determine space charge capacitance at this surface potential using equation $(V_s = -l/2q\epsilon_s \times N_{sc}(l/C_{sc})^2$. The induced charge corresponding to this space charge capacitance can be determined from the measurements shown in Fig. 28. If we assume that the surface state charge for the Fermi Level coinciding with the middle of the band gap (or minimum of the surface state density) is vanishing, then $Q_{ox} = Q_{ind} - Q_{sc}$.

It should be noted that oxide charge measured this way represents total charge in the oxide. This is unlike conventional capacitance methods where the measured oxide charge represents the charge located in the oxide region adjacent to the semiconductor. This difference between the method of this invention and the conventional capacitance methods may be of importance for determination of the total contamination of the dielectric layer (e.g.$SiO_2$ on Si).

The embodiments of the present invention are intended to be merely exemplary and those skilled in the art shall be able to make numerous variations and modifications to it. All such variations and modifications are intended to be within the scope of the present invention as defined in the appended claims.

**Claims**

1. A method of determining a property of a specimen of semiconductor material, the specimen (15) having a known energy gap, the method comprising:

(a) positioning the specimen (15,71) adjacent a pair of electrodes (23,59,97;31,55,79) and with a surface of the specimen (15,71) arranged for illumination,

(b) applying (39) a variable bias voltage ($V_g$) between the pair of electrodes (23,59,97; 31,55,79),

(c) illuminating (33) a region of the said surface (15,71) with a beam of light of wavelengths shorter than that of the energy gap of the semiconductor and being intensity modulated (38) at a predetermined frequency, the intensity of the light beam and frequency of modulation of the light beam being selected so that the surface photovoltage (SPV) induced at the region of the specimen (15,71) illuminated by the light beam is directly proportional to the intensity of the light beam and reciprocally proportional to the frequency of modulation of the light beam,

(d) obtaining from one of the electrodes (23,59,97;31,55,79) a signal ($V_s$) representing the surface photovoltage (SPV) induced at the region of the specimen (15,71) illuminated by the light beam, and

(g) measuring the surface photovoltage (SPV), characterised by positioning the specimen (15) between the pair of electrodes (23,59,97;31,55,79), positioning a solid insulator (25,57,95) between the specimen (15,71) and one of said electrodes, the said one electrode being a reference electrode (23,59,97) and the other electrode being a back electrode (31,55,79), and the reference electrode being smaller than the said surface of the specimen (15,71), and processing (41,43,45,47;118,111,113,115,117) the said signal ($V_s$) to determine the property of the specimen (15,71).

2. A method according to claim 1, characterised by determining (47) the space charge capacitance ($C_{sc}$) from measured surface photovoltage (SPV),

determining (47) the charge ($Q_{sc}$) induced in the semiconductor space-charge region from the space charge capacitance ($C_{sc}$),

determining (47) the charge ($Q_{ind}$) induced in the semiconductor from the bias voltage ($V$)$_g$), and then

determining (47) the surface state density using $Q_{ind}$, $Q_{sc}$ and Vs.

3. A method according to claim 2, characterised by then determining (47) the oxide charge, $Q_{ox}$, using $Q_{ind}$ and $Q_{sc}$ where $Q_{ind}$ and $Q_{sc}$ are the induced charge in the semiconductor and the charge in the space charge region, respectively at the bias voltage ($V_g$), the specimen (15) being arranged with an oxide coating (19) thereof in contact with the solid insulator (25).

4. A method according to claim 1, characterised by determining (47) the polarity of the surface photovoltage (SPV) with the real component at a minimum, the doping type of the specimen (45) being related to the polarity so determined, the surface photovoltage (SVP) having a real component and an imaginary component, and the polarity of the imaginary component being related to the doping type.

5. A method according to claim 1, characterised by determining (47) space charge capacitance ($C_{sc}$) from measured surface photovoltage (SPV), and then determining (47) the doping concentration of the specimen by using the determined space charge capacitance $C_{sc}$.

6. A method according to claim 2, characterised in that: the space charge capacitance ($C_{sc}$) is determined (47) from a signal ($\delta V_s$) representing the surface photovoltage (SPV) using the equation

$$\delta V_s = \frac{\phi(1-R)}{Kf} \times q \, C^{-1}$$

where $\phi$ is the incident photon flux, R is the reflection coefficent of the specimen (15), f is the modulation frequency, q is an elementary charge, and K is 4 if the intensity modulation is square wave and $2\pi$ if it is sinusoidal; in that the semiconductor space-charge ($Q_{sc}$) is determined from the space charge capacitance ($C_{sc}$), using the equation of $Q_{sc} = qN_{sc}W$ where $N_{sc}$ is the average doping concentration in the space charge region, W is width of the depletion layer and q is an elementary charge; in that the charge ($Q_{ind}$) induced in the semiconductor (17) is determined (47) from the bias voltage ($V_g$); and in that the oxide/insulator charge is then determined (47) using the equation $Q_{ox} = \underline{Q_{ind}} - \underline{Q_{sc}}$ where $\underline{Q_{ind}}$ and $\underline{Q_{sc}}$ are the induced charge in the specimen (15) and the semiconducor space charge respectively, the semiconductor (17) having an oxide coating (17) at the said surface and the specimen (15) being arranged with the oxide coating (19) in contact with the solid insulator (25).

**Patentansprüche**

1. Verfahren zur Bestimmung einer Eigenschaft einer Probe aus Halbleitermaterial, wobei die Probe (15) eine bekannte Energielücke hat, enthaltend:

(a) Positionieren der Probe (15,71) angrenzend an ein Elektrodenpaar (23,59,97;31,55, 79) und mit einer zwecks Beleuchtung angeordneten Oberfläche (15,71) der Probe,

(b) Anlegen einer variablen Vorspannung ($V_g$) an das Elektrodenpaar (23,59,97;31,55,79),

(c) Beleuchten (33) eines Bereiches der Oberfläche (15,71) mit einem Lichtstrahl von einer Wellenlänge, die kürzer als die Energielücke des Halbleiters und mit einer vorgegebenen Frequenz intensitätsmoduliert (38) ist, wobei die Intensität des Lichtstrahls und die Modulationsfrequenz desselben so gewählt sind, daß die in dem vom Lichtstrahl beleuchteten Bereich der Probe erzeugte Oberflächenphotospannung (SPV) direkt proportional zur Intensität des Lichtstrahls und umgekehrt proportionial zur Modulationsfrequenz des Lichtstrahls ist,

(d) Erhalten eines Signals ($V_s$) von einer der Elektroden (23,59,97;31,55,59), das die Oberflächenphotospannung (SPV) repräsentiert, die in dem durch den Lichtstrahl beleuchteten Bereich der Oberfläche der Probe (15,71) induziert wird, und

(e) Messen der Oberflächenphotospannung (SPV), gekennzeichnet durch Positionieren der Probe (15) zwischen einem Elektrodenpaar (23,59,97;31,55,79), Positionieren eines festen Isolators (25,27,95) zwischen der Probe und einer der Elektroden, wobei diese eine Elektrode eine Referenzelektrode (31,55,79) ist und wobei die Referenzelektrode kleiner als die besagte Oberfläche der Probe (15,71) ist, sowie Verarbeiten des Signals ($V_s$), um die Eigenschaft der Probe (15,71) zu bestimmen.

2. Verfahren nach Anspruch 1, gekennzeichnet durch die Bestimmung (47) der Raumladungskapazität ($C_{sc}$) aus der gemessenen Oberflächenphotospannung (SPV),
Bestimmung (47) der im Haibieiter-Raumladungsbereich von der Raumladungskapazität ($C_{sc}$) induzierten Ladung ($Q_{sc}$),
Bestimmung (47) der im Halbleiter von der Vorspannung ($V_g$) induzierten Ladung ($Q_{ind}$), und dann
Bestimmung (47) der Oberflächenzustandsdichte unter Verwendung von $Q_{ind}$, $Q_{sc}$ und $V_s$.

3. Verfahren nach Anspruch 2, gekennzeichnet durch die nachfolgende Bestimmung (47) der Oxidladung $Q_{ox}$ unter Verwendung von $Q_{ind}$ und $Q_{sc}$, wobei $Q_{ind}$ und $Q_{sc}$ die induzierte Ladung im Halbleiter bzw. die Ladung im Raumladungsbereich bei der Vorspannung ($V_g$) sind, wobei die Probe (15) mit einer Oxidschicht (19) von ihr im Kontakt mit einem festen Isolator (25) angeordnet ist.

4. Verfahren nach Anspruch 1, gekennzeichnet durch die Bestimmung (47) der Polarität der Oberflächenphotospannung (SPV) mit der Realkomponente an einem Minimum, wobei der Dotierungstyp der Probe (45) in Beziehung zur so bestimmten Polarität steht, und wobei die Oberflächenphotospannung (SPV) eine Real- und eine Imaginärkomponente hat und die Polarität der Imaginärkomponente in Beziehung zum Dotierungstyp steht.

5. Verfahren nach Anspruch 1, gekennzeichnet durch die Bestimmung (47) der Raumladungskapazität ($C_{sc}$) aus der gemessenen Oberflächenphotospannung (SPV) und die nachfolgende Bestimmung (47) der Dotierungskonzentration der Probe unter Verwendung der bestimmten Raumladungskapazität $C_{sc}$.

6. Verfahren nach Anspruch 2, gekennzeichnet dadurch, daß die Raumladungskapazität ($C_{sc}$) unter Verwendung der Gleichung $\delta V_s = [\Phi (1-R) \cdot q \cdot C^{-1}]/Kf$ aus einem Signal ($\delta V_s$) bestimmt (47) wird, welches die Oberflächenphotospannung (SPV) repräsentiert, wobei der einfallende Photonenstrom, R der Reflexionskoeffizient der Probe (15), f die Modulationsfrequenz, q eine Elementarladung und K, wenn die Intensitätsmodulation eine Rechteckwelle ist, gleich 4 und, wenn sie sinusförmig ist, gleich $2\pi$ ist, daß die Halbleiter-Raumladung ($Q_{sc}$) aus der Raumladungskapazität ($C_{sc}$) unter Verwendung der Gleichung $Q_{sc} = q N_{sc} W$ berechnet wird, worin $N_{sc}$ die durchschnittliche Dotierungskonzentration im Raumladungsbereich, W die Breite der Verarmungsschicht und q eine Elementarladung ist; daß die im Halbleiter (17) induzierte Ladung ($Q_{ind}$) aus der Vorspannung ($V_g$) bestimmt (47) wird und daß dann die Oxidisolator-Ladung unter Verwendung der Gleichung $Q_{ox} = Q_{ind} - Q_{sc}$ bestimmt (47) wird, worin $Q_{ind}$ und $Q_{sc}$ die in der Probe (15) induzierte Ladung bzw. die HalbleiterRaumladung sind, wobei der Halbleiter (17) auf der besagten Oberfläche eine Oxidschicht (17) aufweist, und die Probe (15) so angeordnet ist, daß ihre Oxidschicht (19) in Berührung mit dem festen Isolator (25) steht.

**Revendications**

1. Procédé pour déterminer une propriété d'un échantillon d'un matériau semiconducteur, l'échantillon (15) possédant une largeur de bande interdite connue, le procédé consistant à :

(a) positionner l'échantillon (15,71) au voisinage d'un couple d'électrodes (23,59,97; 31,55,79), avec une surface de l'échantillon (15,71) disposée de manière à être éclairée,

(b) appliquer (32) une tension de polarisation variable ($V_g$) entre les électrodes du couple d'électrodes (23,59,97; 31,55,79),

(c) éclairer (33) une région de ladite surface (15,71) avec un faisceau de lumière ayant des longueurs d'onde inférieures à celle de l'intervalle de bande interdite du semiconducteur et étant modulé en intensité (38) à une fréquence prédéterminée, l'intensité du faisceau de lumière et la fréquence de modulation du faisceau de lumière étant sélectionnées de telle sorte que la tension photovoltaïque de surface (SPV) induite dans la région de l'échantillon (15,71) éclairée par le faisceau de lumière est directement proportionnelle à l'intensité du faisceau de lumière et est inversement proportionnelle à la fréquence de modulation du faisceau de lumière,

(d) obtenir à partir de l'une des électrodes (23,59,97; 31,55,79) un signal ($V_s$) représentant la tension photovoltaïque de surface (SPV) induite dans la région de l'échantillon (15,71) éclairée par le faisceau de lumière, et

(g) mesurer la tension photovoltaïque de surface (SPV),

caractérisé par le positionnement de l'échantillon (15) entre les électrodes du couple d'électrodes (23,52,97; 31,55,79), positionner un isolateur solide (25, 57,95) entre l'échantillon (15,71) et une première desdites électrodes, ladite première électrode étant une électrode de référence (23,59,97) et l'autre électrode étant une électrode arrière (31,55,79), et l'électrode de référence étant plus petite que ladite surface de l'échantillon (15,71), et le traitement (41,43,45,47; 118,111,113,115, 117) dudit signal ($V_s$) pour déterminer la propriété de l'échantillon (15,71).

2. Procédé selon la revendication 1, caractérisé par la détermination (47) de la capacité de charge d'espace (Csc) à partir de la tension photovoltaïque mesurée de surface (SPV),

la détermination (47) de la charge (Qsc) induite dans la région de charge d'espace du semiconducteur à partir de la capacité de charge d'espace (Csc),

la détermination (47) de la charge (Qind) induite dans le semiconducteur à partir de la tension de polarisation ($V_g$), puis

la détermination (47) de la densité d'états de surface moyennant l'utilisation de Qind, de Qsc et de Vs.

3. Procédé selon la revendication 2, caractérisé par la détermination ultérieure (47) de la charge d'oxyde Qox, en utilisant Qind et Qsc, Qind et Qsc étant respectivement la charge induite dans le semiconducteur et la charge dans la région de charge d'espace, pour la tension de polarisation ($V_g$), l'échantillon (15) étant disposé de telle sorte qu'un revêtement d'oxyde (19) de l'échantillon est en contact avec l'isolant solide (25).

4. Procédé selon la revendication 1, caractérisé par la détermination (47) de la polarité de la tension photovoltaïque de surface (SPV) avec la composante réelle possédant une valeur minimale, le type de dopage de l'échantillon (45) étant associé à la polarité ainsi déterminée,

la tension photovoltaïque de surface (SVP) possédant une composante réelle et une composante imaginaire, et la polarité de la composante imaginaire étant associée au type de dopage.

5. Procédé selon la revendication 1, caractérisé par la détermination (47) de la capacité de charge d'espace (Csc) à partir de la tension photovoltaïque de surface (SPV) mesurée, puis par la détermination (47) de la concentration de dopage de l'échantillon moyennant l'utilisation de la capacité de charge d'espace Csc déterminée.

6. Procédé selon la revendication 2, caractérisé en ce que : la capacité de charge d'espace (Csc) est déterminée (47) à partir d'un signal ($\delta V_s$) représentant la tension photovoltaïque de surface (SPV) en utilisant l'équation

$$\delta V_s = \frac{\phi(1-R)}{Kf} \times q\, C^{-1}$$

$\phi$ étant le flux de photons incidents, R le coefficient de réflexion de l'échantillon (15), f la fréquence de modulation, q une charge élémentaire et K étant égal à 4 si la modulation en intensité est une onde carrée et à $2\pi$ si elle est sinusoïdale; en ce que la charge d'espace (Qsc) du semiconducteur est déterminée à partir de la capacité de charge d'espace (Csc) moyennant l'utilisation de l'équation Qsc = qNscW, Nsc étant la concentration de dopage moyenne dans la région de charge d'espace, W la largeur de la couche d'appauvrissement et q une charge élémentaire; en ce que la charge (Qind) induite dans le semiconducteur (17) est déterminée (47) à partir de la tension de polarisation ($V_g$); et en ce que la charge de l'oxyde/de l'isolant est ensuite déterminée (47) moyennant l'utilisation de l'équation Qox = Qind - Qsc, Qind et Qsc étant respectivement la charge induite dans l'échantillon (15) et la charge d'espace du semiconducteur, le semiconducteur (17) possédant un revêtement d'oxyde (17) au niveau de ladite surface, tandis que l'échantillon (15) est disposé de telle sorte que le revêtement d'oxyde (19) est en contact avec l'isolant solide (25).

FIG. 1

FIG. 2

FIG. 3

EP 0 325 453 B1

FIG. 4

FIG. 5

FIG. 6

99-1

197-1

199

97-1

197

95

187

FIG. 7

VARIABLE
D C BIAS
VOLTAGE
SOURCE

109

110

103

119

111

AMPLIFIER

99-1

97-1

99

97

99

SPECIMEN

71

79

FIG. 8

131

121

139

123

119

71

FIG. 9

FIG. 10

FIG. 11

FIG. 12

FIG. 13

FIG. 14

FIG. 15

FIG. 16

FIG. 17

FIG. 18

FIG. 19

25

FIG. 20

FIG. 21

FIG. 22

FIG. 23

FIG. 24

FIG. 25

479

473

475

467

485

477

488

483

FIG. 26

481

465    469

463

FIG. 27

P - Si
250Å SiO$_2$

$N_{SC} = N_A = 6.73 \times 10^{14}$ cm$^{-3}$

$Q = +1.2 \times 10^{10}$ q/cm$^2$

FIG. 28

P - Si
250Å SiO2

FIG. 29